# EUROPEAN PATENT APPLICATION

(11) **EP 2 728 663 A1**
(43) Date of publication of application: **07.05.2014**
(21) Application number: 12805290.9
(22) Date of filing: 24.04.2012
(51) Int. Cl.: H01M 14/00, H01L 31/04

(54) **DYE ADSORPTION DEVICE AND DYE ADSORPTION METHOD**

(30) Priority: 29.06.2011 JP 2011144542
(71) Applicant: Tokyo Electron Limited, Tokyo 107-6325 (JP)
(72) Inventor: FURUTANI, Goro, Kumamoto 861-1116 (JP)
(74) Representative: HOFFMANN EITLE
(86) International application number: PCT/JP2012/002809
(87) International publication number: WO 2013/001699

(57) **Abstract**

The purpose of the present invention is to improve the throughput of a dye adsorption process in which a dye is adsorbed in a porous semiconductor layer on a substrate and to improve dye use efficiency. In a dye adsorption device of the present invention, a dye solution drop-coating unit 12 performs a first process (dye solution drop-coating process) on an unprocessed substrate G carried in the dye adsorption device 10, in which a dye solution is dropped and coated on a porous semiconductor layer on the substrate G. A solvent evaporating/removing unit 14 performs a second process (solvent removing process) in which a solvent is evaporated and removed from the dye solution coated on the semiconductor layer on the substrate G. A rinsing unit 16 performs a third process (rinsing process) in which unnecessary or extra dye attached to the surface of the semiconductor layer n the substrate G is rinsed and removed.

## Description

### Technical Field

The present disclosure relates a dye adsorption device for adsorbing a dye to a porous semiconductor layer formed on a surface of a substrate.

### Background

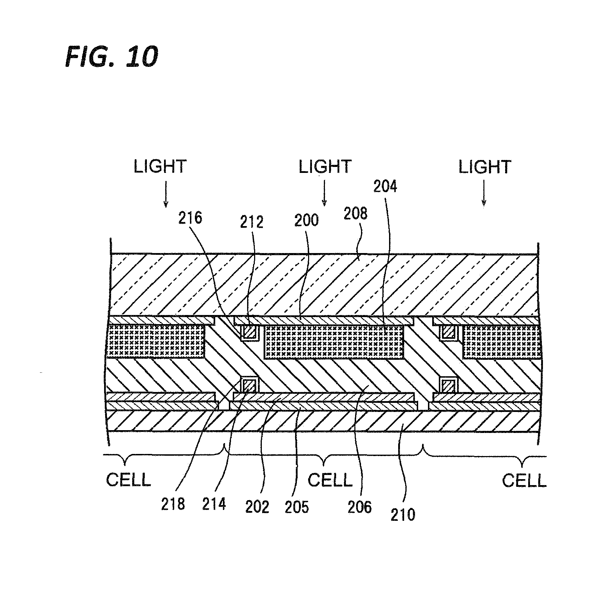

Recently, dye-sensitized solar cells have been regarded as future promising low-cost solar cells. As illustrated in FIG. 10, in a basic configuration of a dye-sensitized solar cell, a porous semiconductor layer (working electrode) 204 configured to carry a sensitizing dye and an electrolyte layer 206 are interposed between a transparent electrode (negative electrode) 200 and an counter electrode (positive electrode) 202. Here, the semiconductor layer 204 is divided into cell units together with the transparent electrode 200, the electrolyte layer 206, and the counter electrode 202. The semiconductor layer 204 is formed on a transparent substrate 208 via the transparent electrode 200. The counter electrode 202 is formed on a counter substrate 210 via a base electrode 205. The transparent electrode 200 of each cell is electrically connected with the neighboring counter electrode 202, and in an entire module, a plurality of cells are electrically connected in parallel or in series. In the illustrated type, a collecting grid wiring 212 is formed on the transparent electrode 200 adjacent to and in parallel to each semiconductor layer (working electrode) 204, and another grid wiring 214 which is the same as the grid wiring 212 is also formed on the counter electrode (positive electrode) 202. Both the grid wirings 212, 214 are covered with protective insulation films 216, 218, respectively.

In the dye-sensitized solar cell configured as described above, the dye carried in the semiconductor layer 204 is excited to emit electrons when visible light is irradiated from the rear side of the transparent substrate 208. The emitted electrons are guided to the transparent electrode 200 via the semiconductor layer 204 and transmitted to the outside. The transmitted electrons are returned to the counter electrode 202 via an external circuit (not illustrated), and received by the dye within the semiconductor layer 204 via ions in the electrolyte layer 206. In this manner, the dye-sensitized solar cell is configured to directly convert light energy into electric power and output the electric power.

In a manufacturing process of such a dye-sensitized solar cell, a method of immersing the semiconductor layer 204 formed on the transparent substrate 208 has been employed in the related art in order to adsorb a sensitizing dye to the porous semiconductor layer 204.

### Prior Art Document

### Patent Document

Patent Document 1: Japanese Patent Laid-Open Publication No. 2006-244954

### Disclosure of the Invention

### Problems to be Solved

The dye adsorption process using the immersing method as described above requires a long process time (typically, 10 or more hours) despite the high consumption of the dye solution and rate-controls the tact of entire process in the dye-sensitized solar cell manufacturing process, thereby causing the deterioration of manufacturing efficiency. With respect to this problem, it may be considered to operate a plurality of immersion type dye adsorption devices in parallel. However, it is not practical because at least dozens of dye adsorption devices should be prepared.

The present disclosure has been made in order to solve the problems in the related art as described above and provides a dye adsorption device which may improve the throughput of a dye adsorption process in which a dye is adsorbed in a porous semiconductor layer formed on a substrate and to improve dye use efficiency.

### Means to Solve the Problems

A dye adsorption device according to the present disclosure is a dye adsorption device of adsorbing a dye to a porous semiconductor layer formed on a substrate. The dye adsorption device includes: a dye solution drop-coating unit provided with a nozzle configured to eject a dye solution obtained by dissolving a dye in a solvent, the dye solution drop-coating unit being configured to drop the dye solution from the nozzle, thereby coating the dye solution on the semiconductor layer on the substrate; a solvent evaporating/removing unit configured to evaporate and remove the solvent from the dye solution coated on the semiconductor layer on the substrate; and a rinsing unit configured to rinse and remove unnecessary dye attached to a surface of the semiconductor layer on the substrate.

A dye adsorption method according to the present disclosure is a dye adsorption method of adsorbing a dye to a porous semiconductor layer formed on a surface to be processed of a substrate. The dye adsorption method includes: a first process of dropping a dye solution obtained by dissolving the dye in a predetermined solvent from a nozzle configured to eject the dye solution, thereby coating the dye solution on the semiconductor layer on the substrate; a second process of evaporating and removing the solvent from the dye solution coated on the semiconductor layer on the substrate; and a third process of rinsing and removing unnecessary dye attached to a surface of the semiconductor layer on the substrate.

In the present disclosure, the dye solution is drop-coated on the semiconductor layer on the substrate so that the dye permeates into the semiconductor layer from a coating film of the dye solution, thereby adsorbing the dye to the individual portions of the semiconductor layer. The dye solution drop-coated on the semiconductor layer on the substrate is forcibly evaporated by the solvent evaporating/removing unit to be substantially completely removed. As a result, the dye is uniformly carried in the semiconductor layer with a high purity. Further, unnecessary dye remaining on the surface of the semiconductor layer is rinsed by the rinsing unit. When the unnecessary dye is rinsed in this manner, the reproducibility and reliability of photoelectric conversion efficiency may be improved.

### Effect of the Invention

According to the dye adsorption device and the dye adsorption method of the present disclosure, through the configurations and operations as described above, the throughput of a dye adsorption process in which a sensitizing dye is adsorbed to a porous semiconductor layer on a substrate may be greatly improved and the dye use efficiency may also be significantly improved by suppressing the usage of the dye solution to a necessary minimum.

### Brief Description of the Drawings

FIG. 1 is a block diagram illustrating a basic configuration of a dye adsorption device in the present disclosure.
FIG. 2 is a vertical cross-sectional view illustrating an entire configuration of a dye adsorption device according to an exemplary embodiment according to the present disclosure.
FIG. 3 is a plan view of the entire configuration of the dye adsorption device of the exemplary embodiment.
FIG. 4 is a perspective view illustrating a configuration of a conveyance mechanism in the dye adsorption device.
FIG. 5 is a vertical cross-sectional view illustrating a dye solution drop-coating module.
FIG. 6 is a view illustrating a corresponding relationship between ejection ports and patterns of a semiconductor layer on a substrate.
FIG. 7 is a cross-sectional view schematically illustrating a state in which the dye in a dye solution coated on a substrate enters into a semiconductor layer.
FIGS. 8A to 8B are perspective views illustrating a configuration of a dye solution evaporation/removing module.
FIG. 9 is a perspective view illustrating a configuration of a rinsing module.
FIG. 10 is a vertical cross-sectional view illustrating a basic configuration of a dye-sensitized solar cell.

### Detailed Description to Execute the Invention

Hereinafter, exemplary embodiments of the present disclosure will be described with reference to the accompanying drawings.

### [Basic Configuration of Device]

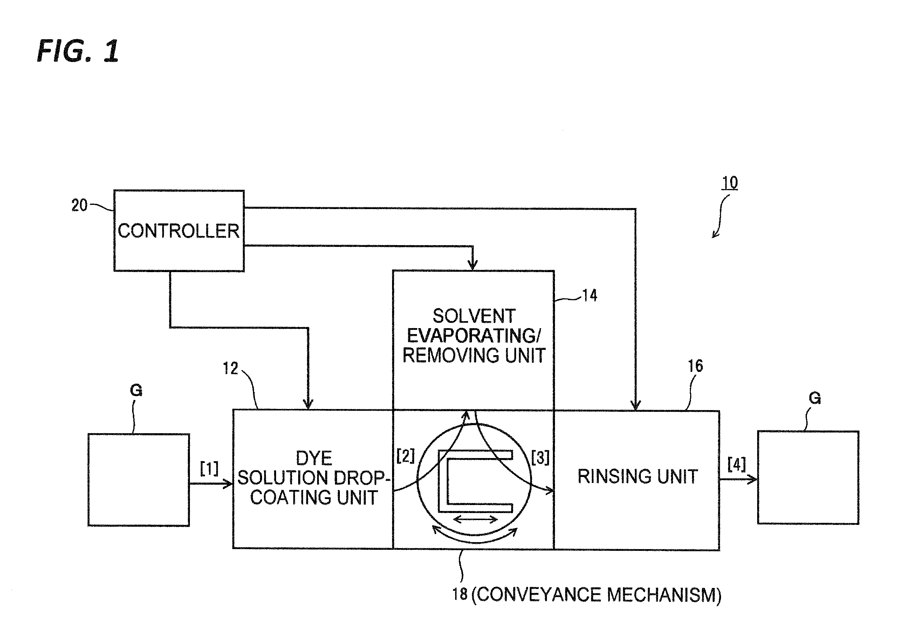

FIG. 1 illustrates a basic configuration of a dye adsorption device in the present disclosure. The dye adsorption device is used in a process in which a sensitizing dye is adsorbed to a porous semiconductor layer in a sheet feed method, for example, in a dye-sensitized solar cell manufacturing process. In such a case, a transparent substrate 208, which is formed with a transparent electrode 200, a porous semiconductor layer 204, a grid wiring 212, and a protective layer 216 thereof (see FIG. 10) before an counter member (counter electrode 202, an counter substrate 210, and an electrolyte layer 206) is combined therewith, is used as a substrate to be processed G in the dye adsorption device.

Here, the transparent substrate 208 is made of a transparent inorganic material such as, for example, quartz or glass, or a transparent plastic material such as, for example, polyester, acryl, or polyimide. The transparent electrode 200 is made of, for example, fluorine-doped SnO₂ (FTO) or indium-tin oxide (ITO). The porous semiconductor layer 204 is made of a metal oxide such as, for example, TiO₂, ZnO, or SnO₂. In addition, the grid wiring 212 is made of a low-resistivity conductor such as, for example, Ag, and the protective layer 216 is made of an insulator such as, for example, a UV-curable resin. The substrate to be processed G has a predetermined shape (e.g., a rectangular shape) and a predetermined size and is carried into/carried out of the dye adsorption device by an external conveyance device (not illustrated) constituted by, for example, a conveyance robot or a conveyance mechanism which is configured to horizontally carry the substrate to be processed G in a horizontal direction (hereinafter, referred to as a "flat-flow conveyance").

As a basic device type, the dye adsorption device 10 includes a dye solution drop-coating unit 12, a solvent evaporating/removing unit 14, a rinsing unit 16, a conveyance mechanism 18, and a controller 20. Here, the dye solution drop-coating unit 12 is configured to perform a first process on an unprocessed substrate G carried into the dye adsorption device 10 so as to drop-coat a dye solution on the porous semiconductor layer 204 on the substrate G (dye solution drop-coating process). The solvent evaporating/removing unit 14 is configured to perform a second process so as to evaporate and remove the solvent from the dye solution coated on the semiconductor layer 204 on the substrate G (solvent removing process). In addition, the rinsing unit 16 is configured to perform a third process so as to rinse and remove an unnecessary or excessive dye attached to the surface of the semiconductor layer 204 on the substrate G (rinsing process). The conveyance mechanism 18 is configured to transfer substrates G one by one among the dye solution drop-coating unit 12, the solvent evaporating/removing unit 14, and the rinsing unit 16. The controller 20 includes a microcomputer and a required interface so as to control the operation of each unit within the dye adsorption device and further, to control the sequence of the entire device for executing the dye adsorption process.

### [Configuration of Device of Exemplary Embodiment]

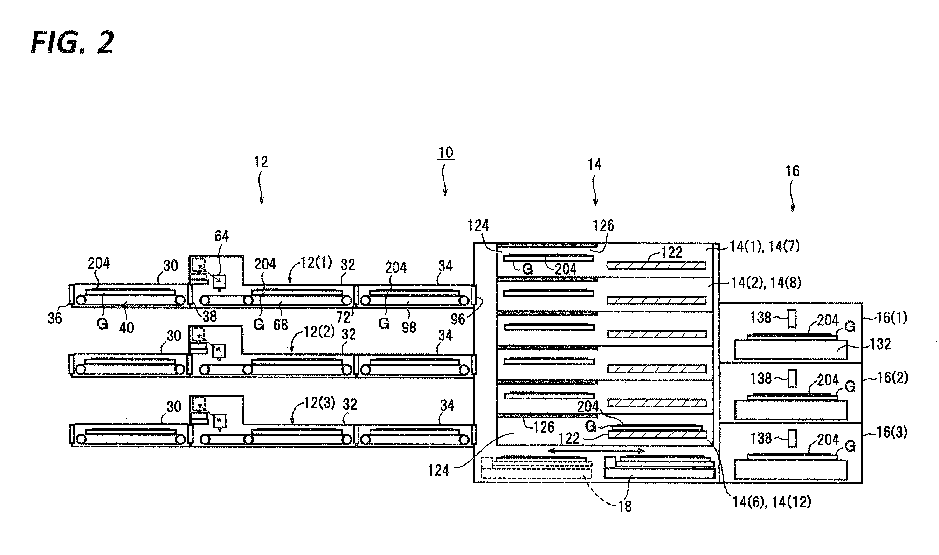

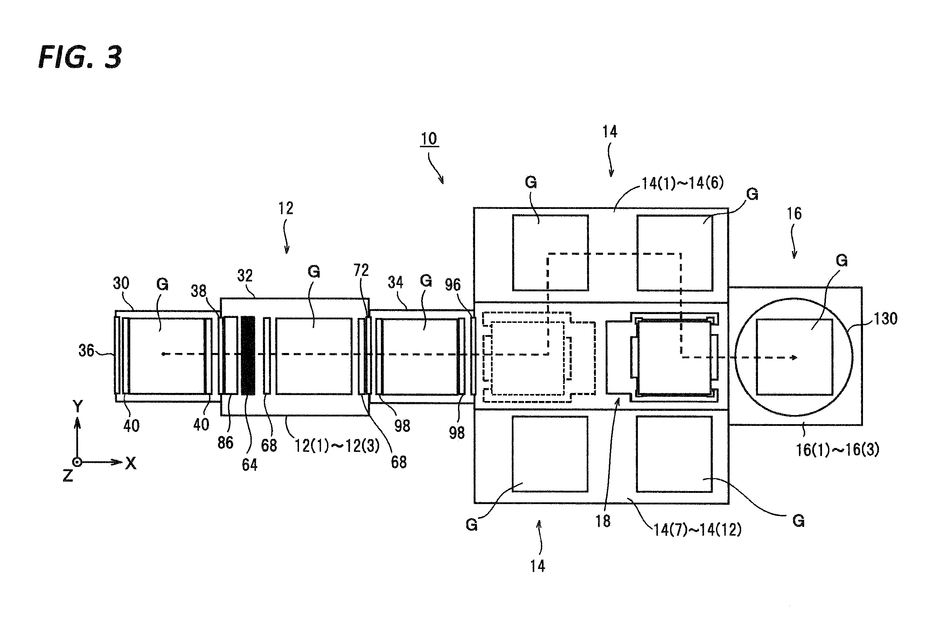

FIGS. 2 and 3 illustrate a detailed configuration of a dye adsorption device 10 according to an exemplary embodiment of the present disclosure. In the exemplary embodiment, each of the processing units 12, 14, 16 is modularized. The dye solution drop-coating unit 12 includes a plurality of (e.g., three) modules 12(1), 12(2), 12(3) which are vertically arranged in parallel to each other such that the three modules may be operated simultaneously (in parallel) with a time difference of tact time (T_{S}). The solvent evaporating/removing unit 14 includes a plurality of (e.g., twelve) modules 14(1), 14(2), ..., 14(12) which are vertically arranged at both sides of the conveyance mechanism 18 such that the twelve modules may be operated simultaneously (in parallel) with the time difference of tact time (Ts). The rinsing unit 16 includes a plurality of (e.g., three) modules 16(1), 16(2), 16(3) which are vertically arranged such that the three modules may be operated simultaneously (in parallel) with the time difference of tact time (T_{S}).

In the dye solution drop-coating unit 12, new or unprocessed substrates G are carried into the three modules 12(1), 12(2), 12(3) sequentially one by one and repeatedly in a cycle of tact time (T_{S}) by an external conveyance device. Meanwhile, the substrates G, for which the dye solution drop-coating process have been finished from the modules 12(1), 12(2), 12(3) in the cycle of tact time (T_{S}), are carried out sequentially one by one and repeatedly by the conveyance mechanism 18. The configuration and operation of each module 12(i) (i=1, 2, 3) will be described in detail below.

The conveyance mechanism 18 carries the substrates G, which have been carried out of the dye solution drop-coating unit 12 in the cycle of tact time (T_{S}), into the modules 14(1), 14(2), ..., 14(12) of the solvent evaporating/removing unit 14 sequentially one by one and repeatedly. Meanwhile, the substrates G, for which the solvent removing process has been finished from the modules 14(1), 14(2), ..., 14(12) in the cycle of tact time (T_{S}), are carried out sequentially one by one and repeatedly by the conveyance mechanism 18. The configuration and operation of each module 14(j) (j=1, 2, ..., 12) will be described in detail below.

The conveyance mechanism 18 carries the substrates G, which have been carried out of the solvent evaporating/removing unit 14 in the cycle of tact time (T_{S}), into the modules 16(1), 16(2), 16(3) of the rinsing unit 16 sequentially one by one and repeatedly ([3]). Meanwhile, the substrates G, for which the rinsing process has been finished from the modules 16(1), 16(2), 16(3) in the cycle of tact time (T_{S}), are carried out sequentially one by one and repeatedly by an external conveyance device. The configuration and operation of each module 16(k) (k=1, 2, 3) will be described in detail below.

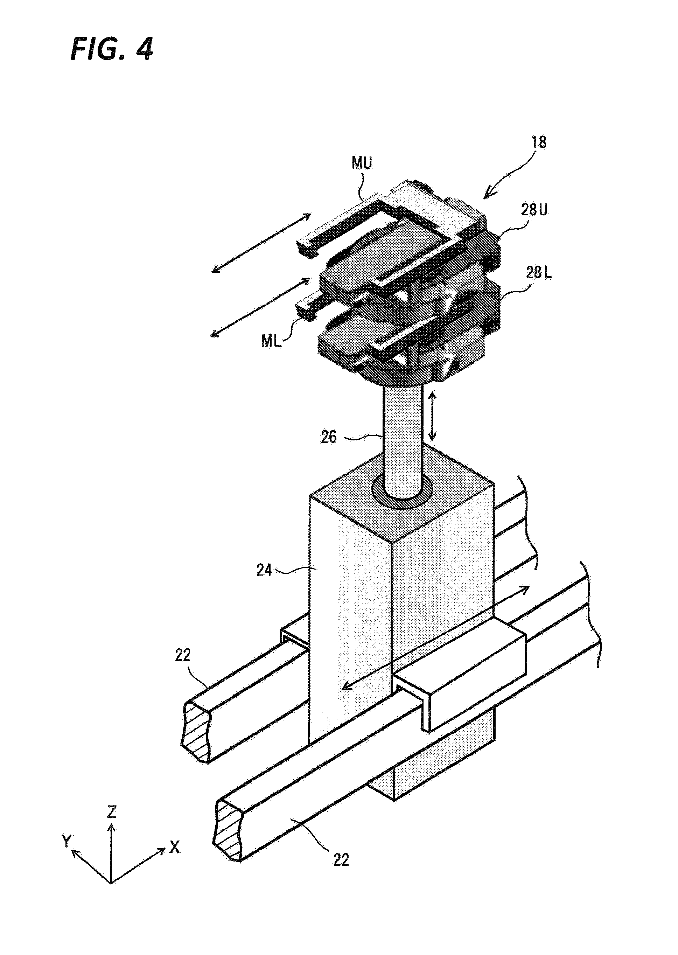

FIG. 4 illustrates the configuration of the conveyance mechanism 18. The conveyance mechanism 18 includes a conveyance base 24 configured to be movable in one horizontal direction (X direction) along, for example, a pair of guide rails 22, and two tiers of upper and lower conveyance arms MU, ML which are rotatable in an azimuthal direction (θ direction) on the conveyance base 24 and liftable in a vertical direction (Z direction) and may independently perform a horizontal back-and-forth or expanding/retracting movement. More specifically, the conveyance mechanism 18 is provided with a lift driving unit (not illustrated), which includes, for example, a linear motor or a ball-screw mechanism, within the conveyance base 24, and upper and lower conveyance bodies 28U, 28L are arranged in two tiers and attached to a lift driving shaft 26 of the lift driving unit to be liftable. Each of the conveyance bodies 28U, 28L is configured to be capable of independently rotating in any direction in the azimuthal direction (8 direction) on the lift driving shaft 26, and both the conveyance arms MU, ML are configured to be capable of independently performing a back-and-forth or expanding/retracting movement on the conveyance bodies 28U, 28L, respectively. Each of the conveyance arms MU, ML is configured to detachably mount, carry or hold one rectangular substrate G.

The conveyance mechanism 18 configured as described above may access to all the modules 12(1), 12(2), 12(3) of the dye solution drop-coating unit 12, all the modules 14(1), 14(2), ..., 14(12) of the solvent evaporating/removing unit 14, and all the modules 16(1), 16(2), 16(3) of the rinsing unit 16. When accessing to each module 12(i) of the dye solution drop-coating unit 12, a substrate G, for which the dye solution drop-coating process has been finished in the corresponding module 12(i), is carried out using any one of the conveyance arms MU, ML. When accessing to each module 14(j) of the solvent evaporating/removing unit 14, a substrate G, for which the solvent removing process has been finished in the corresponding module 14(j), is carried out using any one of the conveyance arms MU, ML, and in exchange for the substrate G, a separate substrate G, which has been transported from the dye solution drop-coating unit 12, is carried in using the other conveyance arm MU, ML. Further, when accessing to each module 16(k) of the rinsing unit 16, a substrate, for which the rinsing process has been finished in the corresponding module 16(k), is carried out using any one of the conveyance arms MU, ML and, in exchange for the substrate G, a separate substrate, which has been carried out and brought from the solvent evaporating/removing unit 14, is carried in using the other conveyance arm MU, ML.

### [Configuration and Operation of Dye Solution Drop-coating Module]

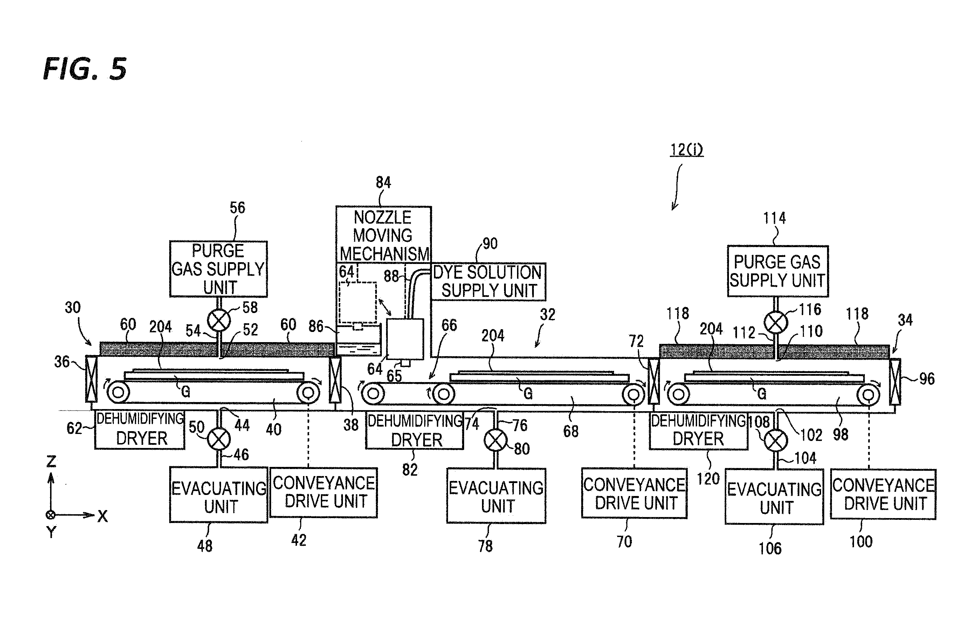

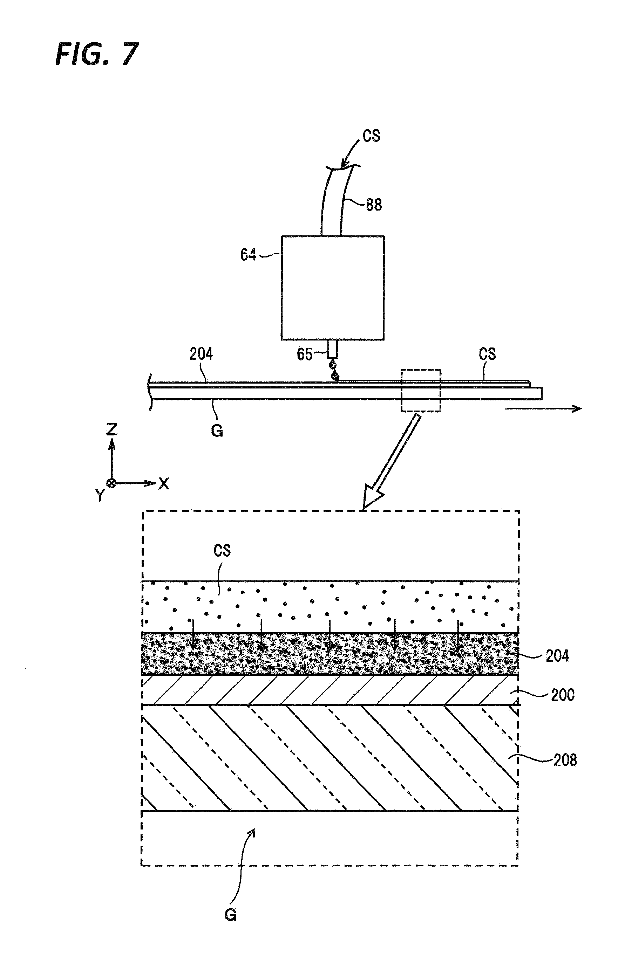

Referring to FIGS. 5 to 7, the configuration and operation of each of the modules 12(i) in the dye solution drop-coating unit 12 will be described.

As illustrated in FIG. 5, the dye solution drop-coating module 12(i) includes three chambers 30, 32, 34 which are cascade-connected to each other in one horizontal direction (X direction). Each of the three chambers 30, 32, 34 may form an atmosphere which is independent from the ambient air. As described below, in the three chambers 30, 32, 34, a pre-process, a main process and a post-process of dye solution drop-coating are adapted to be simultaneously or individually performed in a pipeline method.

A pre-chamber 30 at the front end has a flat space which is suitable for efficiently loading/unloading one substrate G in a flat-flow conveyance manner and is configured such that the atmosphere inside the pre-chamber 30 is switched between an atmospheric pressure condition and a decompressed condition. In order to load or unload the substrate G, an inlet side door valve 36 directed to an ambient air space and an outlet side gate valve 38 configured to be connected with a main chamber 32 at the rear end thereof are attached to side walls of the pre-chamber 30, which are opposite to each other in a flat-flow conveyance direction (X direction), respectively. A conveyor for flat-flow conveyance, for example, a belt conveyer 40 is installed inside the pre-chamber 30 and a conveyance drive unit 42 is installed outside the pre-chamber 30. The conveyance drive unit 42 includes, for example, a motor so as to drive the belt conveyer 40.

The pre-chamber 30 is configured such that the door valve 36 is opened to carry a new substrate G into the pre-chamber 30 under the atmospheric pressure and immediately after that, the door valve 36 is closed and the inside of the pre-chamber 30 is evacuated to be switched into the decompressed condition. For such evacuation, one or plural exhaust ports 44 are provided in the bottom wall of the pre-chamber 30. Each exhaust port 44 is communicated with an evacuating unit 48 through an exhaust tube 46. The evacuating unit 48 includes a vacuum pump or an ejector. An opening/closing valve 50 is mounted on the way of the exhaust tube 46.

In addition, the pre-chamber 30 is configured such that, after the gate valve 38 is opened and the substrate G, for which the pre-process has been finished, is transferred to the neighboring main chamber 32 from the pre-chamber 30, the gate valve 38 is closed and the inside of the pre-chamber 30 is switched from the decompressed condition into the atmospheric pressure condition in order to receive the next new substrate G. For the switching from the decompressed condition to the atmospheric pressure condition, one or plural purge gas inlet ports 52 are provided in the ceiling of the pre-chamber 30. Each purge gas inlet port 52 is connected with a purge gas supply unit 56 through a gas supply tube 54 and an opening/closing valve 58 is mounted on the way of the gas supply tube 54. As for the purge gas, for example, air or nitrogen gas is used. In the exemplary embodiment, because the pre-chamber 30 is configured to have a minimum volume required for loading/unloading one substrate G, both the evacuation and purging may be efficiently performed within a short time.

On the ceiling of the pre-chamber 30, for example, a planar sheath heater 60 as a heating and drying heater is also provided. In addition, at a corner or on the bottom of the pre-chamber 30, a dehumidifying dryer 62 is also provided.

In the configuration of the pre-chamber 30 as described above, a plurality of drying processes such as, for example, decompression by the evacuating unit 48, heating by the sheath heater 60 and/or dehumidifying by the dehumidifying dryer 62, are performed selectively or wholly at once on the semiconductor layer 204 of the substrate G stopped on the belt conveyer 40 over a predetermined length of time (e.g., scores of seconds) as the pre-process of dye solution drop-coating.

In addition, the heating temperature of the sheath heater 60 is set to a value which enables the substrate G in the next process (within the main chamber 32) to be subjected to a main process of dye solution drop-coating at a substrate temperature which is lower than the boiling point of the dye solution. Accordingly, when the boiling point of the dye solution is, for example, 60°C, an upper limit which is slightly higher than 60°C is set for the heating temperature of the sheath heater 60. Although not specifically limited, the pressure of the decompressed atmosphere obtained by the evacuating unit 48 is preferably in the range of 50 mTorr to 100 mTorr in view of both the drying process effects to be obtained and the power utilization efficiency. Further, although not specifically limited, the drying degree obtained by the dehumidifying dryer 62 is preferably in the range of the dew point -30°C to the dew point -50°C in view of both the drying process effects to be obtained and the power utilization efficiency.

The main chamber 32 at the middle portion includes a nozzle 64 configured to drop-eject the dye solution so as to perform the main process of dye solution drop-coating, and a scanning mechanism 66 configured to relatively move the nozzle in relation to the substrate G for coating scanning. The scanning mechanism 66 in the present exemplary embodiment takes a scanning form in which during the processing, the nozzle 64 is maintained at a regular position and the substrate G is passed through just below the nozzle 64 by a flat-flow conveyance mechanism, for example, a belt conveyer 68. A conveyance drive unit 70 is provided outside the chamber 32. The conveyance drive unit 70 includes, for example, a motor configured to drive the belt conveyer 68.

The gate valve 38 becomes the inlet side of the main chamber 32. When the gate valve 38 is opened, the substrate G may be transferred from the neighboring pre-chamber 30 to the main chamber 32 in the flat-flow conveyance manner by both the belt conveyers 40, 68. A gate valve 72 is attached to the outlet side of the main chamber 32 to be connected with the chamber 34 at the rear end.

The inside of the main chamber 32 is configured to be always maintained at the decompressed condition. Thus, the bottom wall of the main chamber 32 is provided with one or plural exhaust ports 74. Each of the exhaust ports 74 is communicated with an evacuating unit 78 through an exhaust tube 76. The evacuating unit 78 includes a vacuum pump. An opening/closing valve 80 is mounted on the way of the exhaust tube 76. In the exemplary embodiment, because the main chamber 32 is configured to have a minimum volume required for accommodating the nozzle 64 and loading/unloading one substrate G, the evacuating may be efficiently continued using the minimum power. Meanwhile, at a corner or on the bottom of the main chamber 32, a dehumidifying dryer 82 is installed. With this configuration, even when the dye solution is drop-coated on the semiconductor layer 204 on the substrate G within the main chamber 32, dehumidification of the inside of the main chamber 32 may be performed by the dehumidifying dryer 82 while forming the decompressed atmosphere inside the main chamber 32 by the evacuating unit 78.

The nozzle 64 is configured to be movable by a nozzle moving mechanism 84 provided on the ceiling of the main chamber 32 between a drop-ejecting position which is opposite to the substrate G on the belt conveyer 68 at a predetermined near distance from the substrate G and a nozzle standby unit 86 provided in the vicinity of the drop-ejecting position. The nozzle standby unit 86 is configured as a solvent storage unit having a top opening corresponding to the nozzle 64 in shape and size. While the nozzle 64 is standing by on the nozzle standby unit 86, the ejection port 65 on the bottom of the nozzle 64 is exposed to the vapor of the solvent within the nozzle standby unit 86 but not to be blocked by the vapor. While the nozzle 64 is being spaced apart from the nozzle standby unit 86, it is desirable to perform local exhaust within the nozzle standby unit 86 by opening an exhaust line (not illustrated) so that the vapor of the solvent does not leak from the nozzle standby unit 86.

The nozzle 64 is connected to a dye solution supply unit 90 through a supply tube 88. The dye solution supply unit 90 includes, for example, a dye solution storage container, a pump configured to suck the dye solution from the dye solution storage container and pressurize and feed the dye solution to the nozzle 64, and a control valve configured to control a flow rate or an amount of dropping per unit time. In addition, the dye solution used in the dye adsorption device is obtained by dissolving a sensitizing dye in a solvent at a predetermined concentration. As for the sensitizing dye, for example, a metal complex such as, for example, a metal phthalocyanine, or an organic dye such as, for example, a cyanin-based dye or a basic dye. As for the solvent, for example, alcohols, ethers, amides, or hydrocarbons may be used.

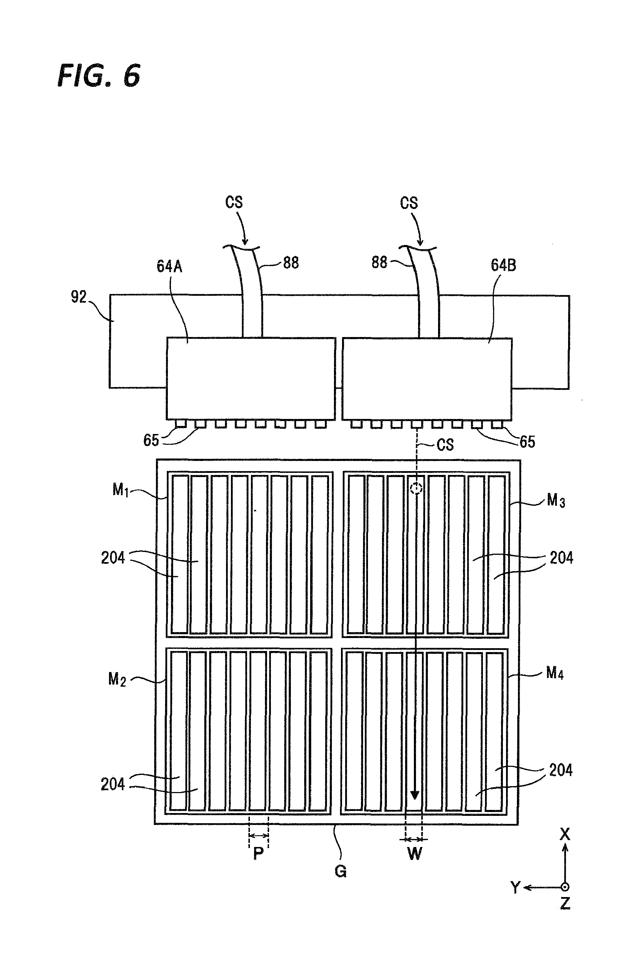

As illustrated in FIG. 6, the nozzle 64 is configured as a long-sized nozzle that extends in a direction lying at right angle to a coating scanning direction (X direction), and hollow pin type or perforated ejection ports 65 are arranged in a row in the longitudinal direction thereof. The diameter and pitch of the ejection ports 65 in the nozzle 64 correspond to the width W and pitch P of cell patterns on the substrate G, that is, the patterns of the semiconductor layer 204.

In the illustrated example, the substrate G is a four-chamfering type from which four solar panels are obtained. A surface to be processed on the substrate G is divided into four product (panel) regions M₁, M₂, M₃, M₄ and a plurality of belt-like patterns of the semiconductor layer 204 are formed in parallel to each other at a constant pitch P in each product region. Here, the belt-like patterns of the semiconductor layer 204 in the first product region M₁ and the belt-like patterns of the semiconductor layer 204 in the second product region M₂ are superimposed with the same straight lines, respectively, and the belt-like patterns of the semiconductor layer 204 in the third product region M₃ and the belt-like patterns of the semiconductor layer 204 in the fourth product region M₄ are superimposed with the same straight lines.

In such a four-chamfering type substrate G, a configuration, in which a half size nozzle 64A is allocated to the first and second product regions M₁, M₂ and another half size nozzle 64B is allocated to the third and fourth product regions M₃, M₄, may be preferably employed. In the drawing, a beam-like support 92 that supports both the nozzles 64A, 64B is coupled to the nozzle moving mechanism 84 (FIG. 5). In addition, when a relative movement between the substrate G and both the nozzles 64A, 64B are performed in parallel to the belt-like patterns of the semiconductor layer 204 in the coating scanning direction (X direction), the dye solution CS drop-ejected from each of the ejection ports 65 of both of the nozzles 64A, 64B hits each corresponding semiconductor layer 204 on the substrate G so that the semiconductor layer 204 on the substrate G may be covered entirely and uniformly by a coating film of the dye solution CS.

Further, in the illustrated example, a non-product region exists between the first and third product regions M₁, M₃ and the second and fourth product regions M₂, M₄, and the semiconductor layer 204 gets cut off once at the non-product region. At a place or region where the semiconductor layer 204 gets cut off, the drop-ejection of the nozzle 64 (nozzles 64A, 64B) may be temporally stopped during the coating scanning. Then, the use efficiency of the dye solution CS may be further improved.

As described above, in the present exemplary embodiment, drying processes (pre-processes) of decompression, heating and/or dehumidification are performed selectively or in a multiple manner within the separate pre-chamber 30, prior to drop-supplying the dye solution CS to the semiconductor layer 204 on the substrate G within the main chamber 32. Further, also within the main chamber 32, a decompressed atmosphere may be formed and dehumidification may also be continuously performed. Because the main process of dye solution drop-coating is performed under the condition where vapor (impurities) attached to or infiltrated into the semiconductor layer 204 in the ambient air are substantially completely removed before the substrate G is carried into the dye adsorption device 10, the dye solutions CS drop-coated on the substrate G may efficiently and rapidly spread out up to the inside of the porous semiconductor layer 204. As a result, the dye in the dye solution CS may be uniformly adsorbed to the semiconductor layer 204 with a high purity.

In the present exemplary embodiment, after the rear end of the substrate G passes through the nozzle 64, the belt conveyer 68 is stopped so that the substrate G pauses for a moment within the main chamber 32. Even during that period, the decompressed condition within the main chamber 32 is maintained. In addition, it is desirable to continuously perform the dehumidification. When the substrate G is left for a moment in the decompressed atmosphere (or decompressed and dehumidified atmosphere just after the main process of dye solution drop-coating is finished, the dye adsorption to the semiconductor layer 204 may be smoothly facilitated on the substrate G.

In facilitating the diffusion of the dye solution CS and the adsorption of the dye to the semiconductor layer 204, it is desirable that the pressure of the decompressed atmosphere formed within the main chamber 32 by the evacuating unit 78 is higher than the pressure of the decompressed atmosphere within the pre-chamber 30 and preferably, in the range of 50 mTorr to 100 mTorr. Meanwhile, although not specifically limited, the drying degree achieved by the dehumidifying dryer 82 is preferably in the range of the dew point -30°C to the dew point -50°C in view of both the dye adsorption facilitating effects to be obtained and power use efficiency.

Because the pipeline method is employed in the dye solution drop-coating module 12(i) in the present exemplary embodiment, a stay time of the substrate G within the main chamber 32, T₃₂, is the same as the stay time within the pre-chamber 30 and may be set in the range of, for example, scores of seconds to one minute.

The post-chamber 34 positioned at the rearmost position has a flat space suitable for loading/unloading one substrate G in a flat-flow conveyance manner and is configured to switch the atmosphere therein between the atmospheric pressure condition and a decompressed condition. In order to load/unload the substrate G, the side walls of the post chamber 34, which are opposite to each other in the flat-flow conveyance direction of the post-chamber 34 (in the X direction), are provided with an inlet side gate valve 72 configured to be connected with the main chamber 32 at the pre-stage, and an outlet side door valve 96 directed toward the ambient air space, respectively. A conveyer for flat-flow conveyance, for example, a belt conveyer 98, is installed within the post-chamber 34, and a conveyance drive unit 100 is installed outside the post-chamber 34. The conveyance drive unit 100 includes, for example, a motor so as to drive the belt conveyer 98.

The post-chamber 34 is configured such that a new substrate G is carried into the post-chamber 34 under a decompressed pressure by opening the gate valve 72, and directly after that, the gate valve 72 is closed and the inside of the post-chamber 34 is purged and switched to the atmospheric pressure or a positive pressure. For evacuation, one or plural exhaust ports 102 are formed in the bottom wall of the post-chamber 34. Each exhaust port 102 is communicated with an evacuating unit 106, which includes a vacuum pump or an ejector, through an exhaust tube 104. An opening/closing valve 108 is provided on the way of the exhaust tube 104. For purging, one or plural purge gas inlet ports 110 are provided in the ceiling of the post-chamber 34. Each purge gas inlet port 110 is connected with a purge gas supply unit 114 through a gas supply tube 112 and an opening/closing valve 116 is mounted on the way of the gas supply tube 112. As for the purge gas, for example, air or nitrogen gas is used. In the present exemplary embodiment, because the post-chamber 34 is configured to have a minimum volume required for loading/unloading one substrate G, both the evacuation and the purging may be efficiently performed within a short time.

On the ceiling of the post-chamber 34, a heating and drying heater, for example, a flat sheath heater 118, is also provided. In addition, at a corner or on the bottom of the post-chamber 34, a dehumidifying dryer 120 is also provided.

In the post-chamber 34 configured as described above, a plurality of drying processes such as, for example, purging by the purge gas supply unit 114 under the atmospheric pressure or a positive pressure, heating by the sheath heater 118 and/or dehumidification by the dehumidifying dryer 120, are performed on the semiconductor layer 204 on the substrate G stopped on the belt conveyer 98 as the post processes of the dye solution drop-coating selectively or all at once over a predetermined length of time (e.g., scores of seconds). The drying processes facilitate the adsorption of the dye in the semiconductor layer 204 while removing the solvent from the dye solution CS drop-coated on the semiconductor layer 204 at a relatively slow speed. The drying processes may be referred to as pre-processes in relation to the next process or second process (solvent evaporation/removing process).

Here, although the heating temperature of the sheath heater 118 may not be specifically limited and may be higher than the boiling point of the dye solution CS because the main process of dye solution drop-coating has been finished. However, when the heating temperature is too high, the semiconductor layer 204 on the substrate G during the dye adsorption may be thermally affected undesirably. Accordingly, it is desirable to suppress the heating temperature not to exceed 200°C. In addition, although not specifically limited, the drying degree achieved by the dehumidifying dryer 120 is preferably in the range of the dew point -30°C to the dew point -50°C in view of the drying process effects to be obtained and power use efficiency.

A stay time of the substrate G within the post-chamber 34, T₃₄ is the same as the stay time within each of the pre-chamber 30 and the main chamber 32, T₃₀, T₃₂.

### [Configuration and Operation of Solvent Evaporating/Removing Unit and Rinsing Unit]

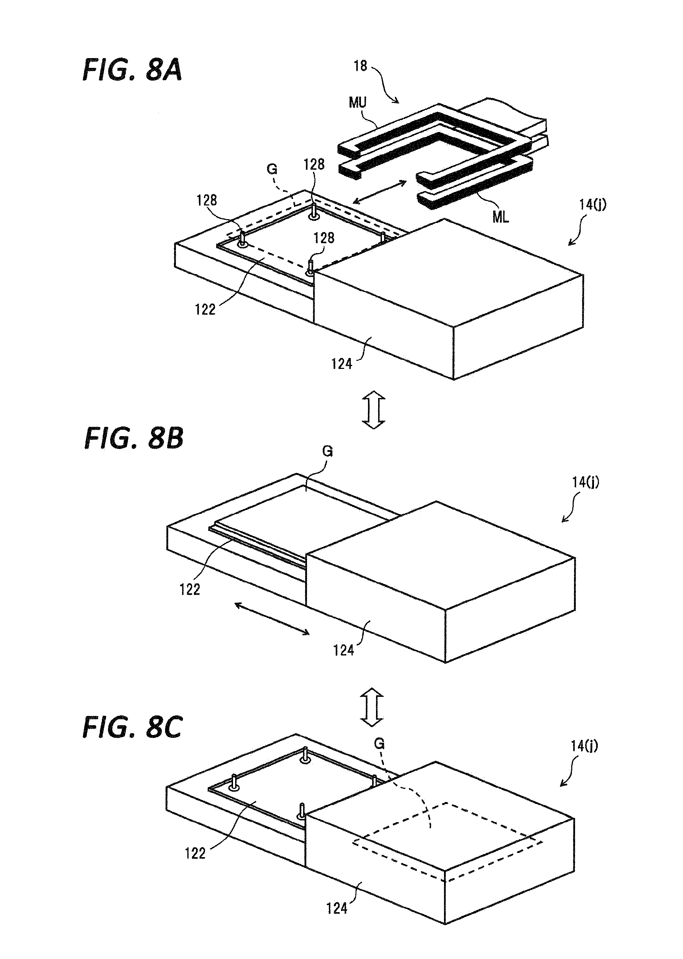

FIGS. 8A to 8C illustrate a configuration of a solvent evaporating/removing module 14(j). The solvent evaporating/removing module 14(j) is configured to load/unload a plate 122 configured to load and convey one substrate G into/out of a main heat treatment chamber in a sliding manner like a drawer. When the conveyance mechanism 18 places a substrate G transferred from the dye solution drop-coating unit 12 using any one of the conveyance arms MU, ML on the plate 122 (FIG. 8A), the plate 122 is slid so as to load the substrate G into the main heat treatment chamber 124. The main heat treatment chamber 124 is provided with a flat heater 126, for example, on the ceiling thereof (see FIG. 2), and the semiconductor layer 204 on the substrate G is heated by the heater 126 at a temperature of 200°C for a length of time of about 1 to 2 minutes, for example. Through this heat treatment, evaporation is performed until the solvent of the dye solution CS attached to the semiconductor layer 204 on the substrate G and the moisture produced in the process of dye adsorption) are substantially completely removed. As a result, the dye will be uniformly carried in the semiconductor layer 204 with a high purity.

While the heat treatment, i.e., the solvent evaporation/removing process as described above, is being performed, the plate 122 stands by outside the main heat treatment chamber 124 (FIG. 8C). In addition, after the solvent evaporation/removing process is finished, the plate 122 enters into the main heat treatment chamber 124 to receive the substrate G and takes out the received substrate G to the outside so that the substrate G is exposed and cooled in the ambient air (FIG. 8B). Then, lift pines 128 provided on the plate 122 are lifted in association with the conveyance arms MU, ML so as to replace the substrate G processed on the plate 122 with the next substrate G (FIG. 8A).

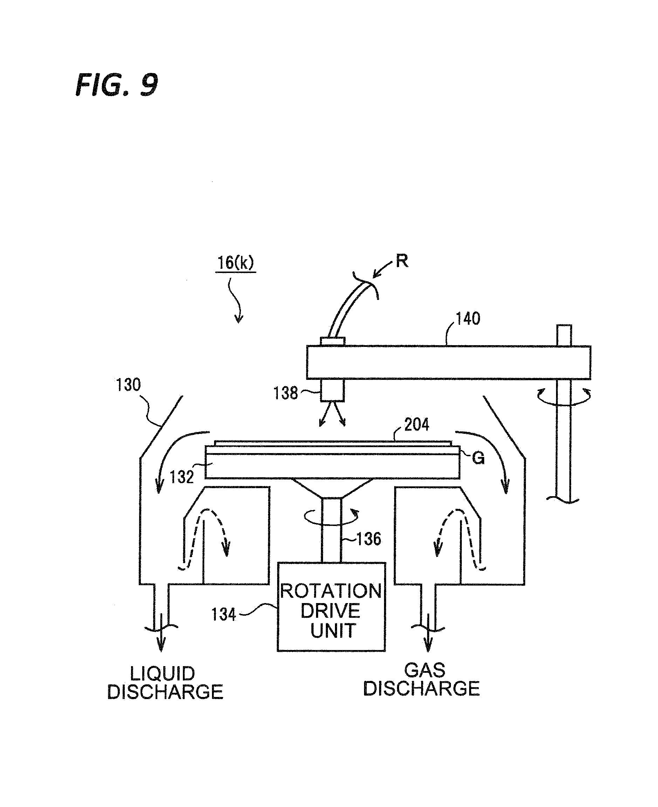

FIG. 9 illustrates a configuration of the main portion of the rinsing module 16(k). The rinsing module 16(k) includes a rotation stage 132 proved at an internal central portion of an annular cup 130. A substrate G is placed on the rotation stage 132 and held by a mechanical or vacuum type chuck mechanism (not illustrated) equipped on the rotation stage 132. In addition, while the substrate G spins together with the rotation stage 132 at a proper speed by a rotation drive unit 134 and through a rotation shaft 136, a rinsing liquid (e.g., pure water) R is sprayed on a surface of the substrate G at a proper flow rate from a nozzle 138 arranged above the substrate G. When the nozzle 138 is a movable type, the nozzle 138 may be reciprocated in the radial direction of the substrate G by turning or shaking an arm 140 that supports the nozzle 138. When the nozzle 138 is a stationary type, a long-sized nozzle, which may cover the entire region of the substrate G with one turning of the substrate G, is desirable. Through the rinsing process, unnecessary dye attached to the surface of the semiconductor layer 204 on the substrate G is removed. After finishing the rinsing process, the rotation stage 132 is rotated at a high speed so that the rinsing liquid attached to the substrate G scatters and the moisture is removed (dried).

When the unnecessary dye attached to the surface of the semiconductor layer 204 on the substrate G is rinsed as described above, the reproducibility and reliability of photoelectric conversion efficiency may be improved.

As described above, the dye adsorption device of the present exemplary embodiment may substantially improve the throughput of a dye adsorption process in which a sensitizing dye is adsorbed to a porous semiconductor layer 204 formed on a surface to be processed on a substrate G as well as substantially improve the dye use efficiency by suppressing the usage of the dye solution to a necessary minimum, in a dye-sensitized solar cell manufacturing process.

### [Other Exemplary Embodiment or Modified Embodiment]

Although an exemplary embodiment of the present disclosure has been described above, the present disclosure is not limited thereto and other exemplary embodiments or various modifications may be made within the technical idea of the present disclosure.

For example, although reduction of module tact may be caused a modular configuration may also be adopted in the dye solution drop-coating unit 12 such that the pre-process, the main process and the post-process of dye solution drop-coating may be executed using two chambers or a single chamber. In such a case, a purge mechanism may be additionally provided in the main chamber 32 so that the evacuation by the evacuating unit 78 and the purging by the purge mechanism may be alternately performed.

Alternatively, a modular configuration may also be adopted in the dye solution drop-coating unit 12 such that the main process of dye solution drop-coating may be performed under the atmospheric pressure or a positive pressure. In such a case, the evacuating unit 78 may be omitted.

Each unit within a dye solution drop-coating module 12(i) may also be variously modified. For example, the flat-flow conveyance mechanism within the dye solution drop-coating module 12(i) is not limited to a belt conveyer but may be a roller conveyer, for example. Alternatively, instead of the flat-flow conveyance mechanism, it is also possible to constitute an equipment such that a conveyance robot may perform any operation for loading/unloading of a substrate using a conveyance arm.

In addition, in order to perform the main process of dye solution drop-coating (coating scanning), the substrate G may be stopped and the nozzle 64 may be moved in the horizontal direction. In the above-described exemplary embodiment (FIG. 6), performing the scanning of drop-coating in a direction parallel to the belt like patterns (in the X direction) is a preferable aspect of the present disclosure. However, other aspect may be adopted. For example, the scanning of the drop-coating may also be performed in a direction semiconductor layer 204 lying at right angles to the belt-like patterns (in the Y direction). In such a case, the dye solution may be drop-ejected intermittently only when the nozzle 64 passes over (across) the semiconductor layer 204 during the scanning movement. Alternatively, an aspect in which the nozzle 64 may scan the substrate G from one end of the substrate G to the other end while continuously drop-ejecting the dye solution may be adopted although it may increase the usage of the dye solution. The nozzle 64 may have a slit-like ejection port.

As described above, the present disclosure may be advantageously applied to a process of adsorbing a sensitizing dye to a porous semiconductor layer in a dye-sensitized solar cell manufacturing process. However, the present disclosure may also be applicable to a process of adsorbing an optional dye to an optional film (especially, a porous film) formed on a surface of a substrate.

### [Description of Symbol]

10: dye adsorption device
12: dye solution drop-coating unit
12((1) to 12(3), 12(i): dye solution drop-coating module
14: solvent evaporating/removing unit
14((1) to 14(12), 14(j): solvent evaporating/removing module
16: rinsing unit
16((1) to 16(3), 16(k): rinsing module
18: conveyance mechanism
20: controller
30: pre-chamber
32: main chamber
34: post-chamber
40, 68, 98: belt conveyer
48, 78, 106: evacuating unit
56, 114: purge gas supply unit
60, 118: sheath heater
62, 82, 120: dehumidifying dryer
64: nozzle
90: dye solution supply unit

## Claims

1. A dye adsorption device of adsorbing a dye to a porous semiconductor layer formed on a substrate, the dye adsorption device comprising:
a dye solution drop-coating unit provided with a nozzle that ejects a dye solution obtained by dissolving a dye in a solvent, the dye solution drop-coating unit being configured to drop the dye solution from the nozzle, thereby coating the dye solution on the semiconductor layer on the substrate;
a solvent evaporating/removing unit configured to evaporate and remove the solvent from the dye solution coated on the semiconductor layer on the substrate; and
a rinsing unit configured to rinse and remove unnecessary dye attached to a surface of the semiconductor layer on the substrate.

2. The dye adsorption device of claim 1, wherein the nozzle includes a plurality of ejection ports having a diameter and a pitch according to patterns of the semiconductor layer formed on the substrate.

3. The dye adsorption device of claim 1, wherein the dye solution drop-coating unit includes a scanning mechanism configured to cause a relative movement between the nozzle and the substrate such that a coating film of the dye solution on the substrate covers the semiconductor layer entirely.

4. The dye adsorption device of claim 1, wherein the dye solution drop-coating unit includes a first chamber configured to form an atmosphere that is independent from the ambient air, the drop-coating of the dye solution on the semiconductor layer of the substrate being performed within the first chamber.

5. The dye adsorption device of claim 4, further comprising a first evacuating unit configured to decompress the inside of the first chamber.

6. The dye adsorption device of claim 4, further comprising a first dehumidifying dryer configured to dehumidify the inside of the first chamber.

7. The dye adsorption device of claim 4, further comprising a first conveyance mechanism configured to perform loading/unloading of the substrate into/out of the first chamber in a flat flow manner.

8. The dye adsorption device of claim 1, wherein the dye solution drop-coating unit includes a second chamber configured to form an atmosphere that is independent from the ambient air, a predetermined pre-process prior to the drop-coating of the dye solution on the semiconductor layer on the substrate being performed within the second chamber.

9. The dye adsorption device of claim 8, further comprising a second evacuating unit configured to decompress the inside of the second chamber.

10. The dye adsorption device of claim 8, further comprising a first heating unit configured to heat the surface of the semiconductor layer on the substrate within the second chamber.

11. The dye adsorption device of claim 8, further comprising a second dehumidifying dryer configured to dehumidify the inside of the second chamber.

12. The dye adsorption device of claim 8, wherein further comprising a second conveyance mechanism configured to loading/unloading the substrate into/out of the inside of the second chamber.

13. The dye adsorption device of claim 4, wherein dye solution drop-coating unit includes a third chamber configured to form an atmosphere that is independent from the ambient air, a predetermined post-process continued to the drop-coating of the dye solution on the semiconductor layer on the substrate being performed within the third chamber.

14. The dye adsorption device of claim 13, further comprising a purge mechanism configured to supply a purge gas into the third chamber so as to develop an atmospheric pressure condition or a positive pressure condition in the inside of the third chamber.

15. The dye adsorption device of claim 13, further comprising a second heating unit configured to heat the surface of the semiconductor layer of the substrate within the third chamber.

16. The dye adsorption device of claim 13, further comprising a third dehumidifying dryer configured to dehumidify the inside of the third chamber.

17. The dye adsorption device of claim 13, further comprising a third conveyance mechanism configured to load/unload the substrate into/out of the inside of the third chamber in a flat flow manner.

18. A dye adsorption method of adsorbing a dye to a porous semiconductor layer formed on a surface to be processed of a substrate,
a first process of dropping a dye solution obtained by dissolving the dye in a predetermined solvent on the semiconductor layer from a nozzle configured to eject the dye solution, thereby coating the dye solution on the substrate;
a second process of evaporating and removing the solvent from the dye solution coated on the semiconductor layer on the substrate; and
a third process of rinsing and removing unnecessary dye attached to a surface of the semiconductor layer on the substrate.

19. The dye adsorption method of claim 18, wherein, using the nozzle that includes a plurality of ejection ports having a diameter and a pitch according to patterns of the semiconductor layer formed on the substrate, the dye solution drop-ejected from the ejection ports of the nozzle is coated only in a pattern region of the semiconductor layer.

20. The dye adsorption method of claim 18, wherein, in the first process, a relative movement is caused between the nozzle and the substrate such that a coating film of the dye solution on the substrate covers the semiconductor layer entirely.
